(19) Europäisches Patentamt
European Patent Office
Office européen des brevets

(11) EP 1 996 658 B1

(12) **EUROPEAN PATENT SPECIFICATION**

(45) Date of publication and mention of the grant of the patent:
**12.05.2010 Bulletin 2010/19**

(21) Application number: **07715349.2**

(22) Date of filing: **16.03.2007**

(51) Int Cl.:
***C09D 7/12*** *(2006.01)* ***C09D 7/06*** *(2006.01)*

(86) International application number:
**PCT/JP2007/056131**

(87) International publication number:
**WO 2007/108550 (27.09.2007 Gazette 2007/39)**

(54) **RESIN COMPOSITION**

HARZZUSAMMENSETZUNG

COMPOSITION DE RESINE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **17.03.2006 JP 2006074635**

(43) Date of publication of application:
**03.12.2008 Bulletin 2008/49**

(73) Proprietor: **SHOWA DENKO K.K.**
**Tokyo 105-8518 (JP)**

(72) Inventors:
- **UCHIDA, Hiroshi**
  **c/o SHOWA DENKO K.K.**
  **Kawasaki-shi, Kanagawa 2100867 (JP)**
- **INOUE, Hirofumi**
  **c/o SHOWA DENKO K.K.**
  **Kawasaki-shi, Kanagawa 2100867 (JP)**

(74) Representative: **Strehl Schübel-Hopf & Partner**
**Maximilianstrasse 54**
**80538 München (DE)**

(56) References cited:
**US-A- 5 266 455**
**US-A- 5 824 461**
**US-A1- 2003 092 862**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 996 658 B1

## Description

### TECHNICAL FIELD

The present invention relates to a paste thermosetting resin composition for overcoating, excellent in antifoaming property and leveling property at the time of printing without using a silicone defoaming agent, which can provide a flexible circuit board excellent in adhesion with substrate, warpage resistance, flexibility, plating resistance, soldering heat resistance and long-term reliability at high temperature and high humidity, an overcoating agent using the composition, surface-protection film using the agent, an ink for permanent-insulation surface-protection film, cured products of the composition and electronic components using the cured product.

### BACKGROUND ART

Conventionally, as a surface protection film of flexible wiring circuit, types of insulating protection film called cover-lay film (such as polyimide film) to be applied onto a metal mold having a pattern as desired by using an adhesive and types of film having flexibility formed by applying UV-cured or heat-cured overcoating agent in screen-printing method have been used, and in particular, the latter type using heat-cured overcoating agent is excellent in workability.

Known examples of such a thermosetting overcoating agent mainly include epoxy resin-based ones, acrylic resin-based ones and composite type resin compositions consisting of these resins. In most cases, such a agent contains as its main component a resin composition modified by incorporating butadiene skeleton, siloxane skeleton, polycarbonate skeleton or long-chain aliphatic skeleton and therefore, by using the agent, flexibility can be enhanced and warpage due to curing contraction can be suppressed while reduction in heat resistance, chemical resistance and electrical insulating property inherent in the surface protection film is kept to a minimum level.

However, with recent reduction in size and weight of electronic devices, as flexible substrates tend to be lighter and thinner, flexibility and curing contraction of resin composition for overcoating are exerting more and more influence. Thus, it is still the case that conventional types of curable overcoating agent cannot satisfy required performance in terms of flexibility and warpage due to curing contraction.

If air is involved in preparation of a paste resin composition for such a surface protection film, fine froths (air bubbles) generate, which causes generation of voids or pinholes. For the purpose of preventing this, it is general to blend a little amount of defoaming agent in the paste resin composition. Such a silicone-based defoaming agent, which has excellent defoaming activity, can reduce froths present in the paste resin composition for surface protection film to a very small amount and therefore is very effective in preventing generation of voids and pinholes.

However, silicone-based defoaming agent has low compatibility with other resins and has high heat resistance. Therefore, in the process of mounting a device on a flexible board, sealing the whole with resin and then heat-curing it, silicone-based defoaming agent oozes on the surface of the resin for protection film and repels the sealing agent, which is disadvantageous in that the bonded device cannot be completely sealed.

Also, if defoaming agent oozing out during the process of curing the paste resin composition for protection film is attached on a surface of an inner lead or the like, removal of the composition is very difficult and moreover, contact failure may readily occur between the inner lead and the bump of the device.

In order to solve these problems, Japanese Patent Application Laid-Open No. 2001-59071 discloses a solder-resist coating solution forming fewer pinholes even without using a silicone-based defoaming agent. However, this technique, where even a small mismatch in conditions causes air bubbles to remain, involves too great an obstacle to put into industrial practice.

Practically, it is very difficult to defoam in the paste resin composition without using a silicone-based defoaming agent. Although studies are being made on how to reduce the use amount of silicone-based defoaming agent as described in Japanese Patent Application Laid-open Nos. 2003-327913 and 2004-124015, no drastic solution for improvement has yet been proposed.

### DISCLOSURE OF INVENTION

The present invention relates to a paste thermosetting resin composition for overcoating, excellent in antifoaming property and leveling property at the time of printing without using a silicone defoaming agent, and also excellent in adhesion with substrate, warpage resistance, flexibility, plating resistance, soldering heat resistance and long-term reliability at high temperature and high humidity, an overcoating agent using the composition and surface-protection film using the agent.

With a view to solving the above problems, the present inventors have made intensive studies and as a result, they have found out that by allowing surfactant containing specific fluorine to be contained in the paste resin composition, the above object can be attained. In particular, by combining a specific a urethane resin having a specific carboxyl-group

as thermosetting resin with an epoxy resin, a paste resin composition for surface protection film, which is very flexible and excellent in electric insulation, can be obtained.

That is, the present invention relates to the following 1 to 29.

1. A thermosetting resin composition comprising the following components (A) to (C):

    (A) thermosetting resin,
    (B) inorganic fine particles and/or organic fine particles, and
    (C) fluorine-containing polyether.

2. The thermosetting resin composition described in 1 above, wherein the blended amounts of the thermosetting resin as component (A), the inorganic fine particles and/or the organic fine particles as component (B) and the fluorine-containing polyether as component (C) based on the total amount of the thermosetting resin are as follows:

    (A) from 20 to 90 mass%,
    (B) from 10 to 80 mass% and
    (C) from 0.1 to 5 mass%.

3. The thermosetting resin composition described in 2 above, wherein the blended amounts of the thermosetting resin as component (A), the inorganic fine particles and/or the organic fine particles as component (B) and the fluorine-containing polyether as component (C) based on the total amount of the thermosetting resin are as follows:

    (A) from 40 to 90 mass%,
    (B) from 10 to 60 mass% and
    (C) from 0.1 to 5 mass%.

4. The thermosetting resin composition described in any one of 1 to 3 above, wherein (C) fluorine-containing polyether is a polymer having a fluorinated alkyl polyoxetane structure represented by formula (1) or (2),

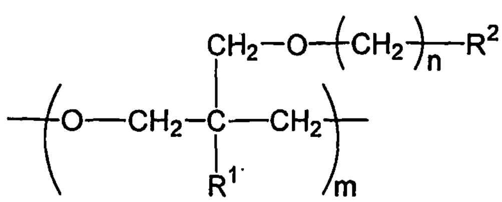

(1)

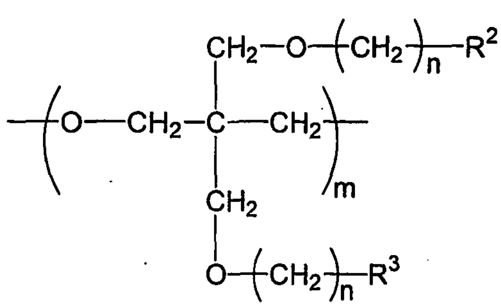

(2)

(In the formula, m is an integer of 1 to 100, n is an integer of 1 to 6, $R^1$ represents a hydrogen atom or an alkyl group having 1 to 6 carbon atoms, $R^2$ and $R^3$ each individually represent a straight-chain or branched chain alkyl group having 1 to 20 carbon atoms, with a proviso that at least 50 % of hydrogen atoms present in the alkyl group is substituted by fluorine atoms and the other hydrogen atoms are substituted by hydrogen atoms, iodine atoms, chlorine atoms or bromine atoms.) or a composition containing copolymer which consists of a monomer having a fluorinated alkyl polyoxetane structure and an oxygen-containing monomer having 2 to 6 carbon atoms.

5. The thermosetting resin composition described in 4 above, wherein m in the formulae (1) and (2) represents an integer of 2 to 30.
6. The thermosetting resin composition described in 4 above, wherein at least 75 % of hydrogen atoms present in the straight-chain or branched chain alkyl group having 1 to 20 carbon atoms represented by $R^2$ and $R^3$ in formulae (1) and (2) is substituted by fluorine atoms.
7. The thermosetting resin composition described in 4 above, wherein in formulae (1) and (2), m is an integer of 2 to 30, n is an integer of 1 to 3, $R^1$ represents a methyl group or an ethyl group, $R^2$ and $R^3$ represent a straight-chain or branched chain alkyl group having 1 to 7 carbon atoms and at least 95 % of hydrogen atoms present in the alkyl group is substituted by fluorine atoms
8. The thermosetting resin composition described in any one of 1 to 7 above, wherein the number-average molecular weight of fluorine-containing polyether (C) is in a range of 300 to 10000.
9. The thermosetting resin composition described in any one of 1 to 8 above, wherein thermosetting resin (A) contains at least one resin component selected from the group consisting of epoxy resin, modified elastomer of epoxy resin, urethane resin, modified elastomer of urethane resin, polyimide resin, modified elastomer of polyimide resin and those resins modified with acrylic acid.
10. The thermosetting resin composition described in any one of 1 to 9 above, wherein the thermosetting resin(A) contains carboxyl group-containing urethane resin obtained by allowing the following materials to react:

(a) polyisocyanate compound,
(b) polyol compound,
(c) dihydroxy compound having a carboxyl group, and if necessary,
(d) monohydroxy compound and
(e) monoisocyanate compound.

11. The thermosetting resin composition described in 10 above, wherein the blending molar ratio of (a) diisocyanate compound,(b) polycarbonate diol, (c) dihydroxy compound, (d) monohydroxy compound and (e) monoisocyanate compound is as follows:

(a):((b)+(c))=from 0.5 to 1.5:1 and,
(b):(c) =1: from 0.1 to 30,

and further in a case where (d) is used, the ratio is as follows:

((b)+(c))≤(a) and preferably, the amount of (d) is from 0.5 to 1.5 times by mol based on excessive number of moles of NCO group,

in a case where (e) is used, the ratio is as follows:

(a)<((b)+(c)), and the amount of (e) is from 0.5 to 1.5 times by mol based on excessive number of moles of hydroxyl group.

12. The thermosetting resin composition described in 11 above, wherein the blending molar ratio of (a) diisocyanate compound,(b) polycarbonate diol, (c) dihydroxy compound,(d) monohydroxy compound and (e) monoisocyanate compound is as follows:

(a):((b)+(c)) = from 0.8 to 1.2:1,
(b):(c) = 1:from 0. 3 to 10,

further in a case where (d) is used, the ratio is as follows:

((b)+(c)) ≤ (a) and preferably, the amount of (d) is from 0.8 to 1.2 times by mol based on excessive number of moles of NCO group, and

in a case where (e) is used, the ratio is as follows:

(a)<((b)+(c)) and the amount of (e) is from 0.8 to 1.2 times by mol based on excessive number of moles of hydroxyl group.

13. The thermosetting resin composition described in 10 above, wherein the polyisocyanate compound(a) for preparing the carboxyl group-containing urethane resin is at least one compound selected from the group consisting of 1,4-cyclohexane diisocyanate, isophorone diisocyanate, methylene bis(4-cyclohexyl isocyanate), cyclohexane-1,3-dimethylene diisocyanate and cyclohexane-1,4-dimethylene diisocyanate.

14. The thermosetting resin composition described in any one of 10 to 13 above, wherein the polyol compound (b) described in 10 above is at least one kind selected from the group consisting of polycarbonate polyol, polyether polyol, polyester polyol, polylactone polyol, polybutadiene polyol, hydroxyl-terminated polysilicone (with both terminals hydroxylated) and polyol compound having 18 to 72 carbon atoms in its constituents and not containing oxygen except for oxygen present in hydroxyl group.

15. The thermosetting resin composition described in any one of 10 to 14 above, wherein carboxyl group-containing dihydroxy compound (c) described in 10 is 2,2-dimethylol propionic acid or 2,2-dimethylol butanoic acid.

16. The thermosetting resin composition described in any one of 10 to 15 above, wherein the monohydroxy compound (d) described in 10 is at least one compound selected from the group consisting of 2-hydroxyethyl acrylate, 2-hydroxyethyl (meth)acrylate (hereinafter, the two are referred to as "2-hydroxyethyl (meth)acrylate"), hydroxypropyl (meth)acrylate, hydroxybutyl (meth)acrylate, cyclohexane dimethanol mono(meth)acrylate, caprolactone or alkylene oxide adduct of the above(meth)acrylate compounds, glycerine di(meth)acrylate, trimethylolpropane di(meth)acrylate, pentaerythritol tri(meth)acrylate, dipentaerythritol penta(meth)acrylate, ditrimethylolpropane tri(meth)acrylate, allyl alcohol, allyloxy ethanol, 1,4-butanediol monovinyl ether, cyclohexane dimethanol monovinylether, glycolic acid, hydroxypivalic acid, lactic acid, malic acid, citric acid, 2-hydroxyethyl propionic acid, hydroxyisobutyric acid, methanol, ethanol, n-propanol, isopropanol, n-butanol, isobutanol, sec-butanol and t-butanol, amylalcohol, hexylalcohol and octylalcohol.

17. The thermosetting resin composition described in any one of 10 to 16 above, wherein the monoisocyanate compound (e) described in 10 is at least one compound selected from the group consisting of(meth)acyloyloxyethyl isocyanate, 2-hydroxyethyl(meth)acrylate for diisocyanate compound, hydroxypropyl (meth)acrylate, hydroxybutyl (meth)acrylate, cyclohexane dimethanol mono(meth)acrylate, caprolactone or alkylene oxide adduct of each of the above-mentioned (meth)acrylates, glycerine di(meth)acrylate, trimethylolpropane di(meth)acrylate, pentaerythritol tri(meth)acrylate, dipentaerythritol penta(meth)acrylate, ditrimethylol propane tri(meth)acrylate, allyl alcohol, and mono-adduct of allyloxyethanol.

18. The thermosetting resin composition described in any one of 10 to 17 above, wherein the number average molecular weight of the carboxyl group-containing urethane resin is in a range of 1000 to 100000 and the acid value is in a range of 5 to 120 mg -KOH/g.

19. The thermosetting resin compositions described in 18 above, wherein the number average molecular weight of the carboxyl group-containing urethane resin is in a range of 3000 to 50000 and the acid value is in a range of 10 to 70 mg -KOH/g.

20. The thermosetting resin composition described in any one of 10 to 19 above, containing polyepoxy compound as curing agent for carboxyl group-containing urethane resin.

21. The thermosetting resin composition described in 20 above, wherein the curing agent is an epoxy resin selected from the group consiting of bisphenol-A, bisphenol-F and/or hydrogenated type of these resins.

22. The thermosetting resin composition described in 21 above, wherein the curing agent is alicyclic epoxy compound.

23. The thermosetting resin composition described in any one of 1 to 22 above, containing the inorganic and/or organic fine particles(B) described in 1 above at 5 to 40 mass % based on the total amount of the thermosetting resin composition, wherein the inorganic fine particle is at least one kind selected from the group consisting of silica, alumina, titanium oxide, barium sulfate, talc, calcium carbonate, glass powder and quartz powder, and the organic fine particle is at least one kind selected from the group consisting of epoxy resin powder, melamine resin powder, urea resin powder, guanamine resin powder, polyester resin powder and silicone powder.

24. The thermosetting resin composition described' in any one of 1 to 23 above, wherein the fluorine-containing polyether (C) described in above 1 is copolymer of epoxy cpompound, oxetane compound and/or tetrahydrofuran derivative and fluorooxetane.

25. An overcoating agent comprising the thermosetting resin composition described in any one of 1 to 24 above.

26. The surface protection film for substrate of flexible circuit boards, comprising the overcoating agent described in 25 above.

27. An ink for permanent insulating protective film comprising the thermosetting resin composition described in any one of 1 to 26 above.

28. A cured prodcut obtained by curing the ink for permanent insulating protective film described in 27 above.

29. An electronic component comprising the cured product described in 28 above.

The thermosetting resin composition of the present invention gives a paste thermosetting resin composition, an overcoating agent and a surface protective film, excellent in antifoaming property and leveling property at the time

of printing without using a silicone-based defoaming agent, and also excellent in adhesion with substrate, flexibility, warpage resistance, plating resistance, soldering heat resistance and long-term reliability at high temperature and high humidity, an overcoating agent and surface protective film using the agent.

## BEST MODE FOR CARRYING OUT THE INVENTION

The thermosetting resin composition and material for forming protective film is explained in further detail hereinbelow.

The present invention is a paste thermosetting resin composition comprising the following components (A), (B) and (C).

(A) thermosetting resin,
(B) inorganic fine particles and/or organic fine particles,and
(C) fluorine-containing polyether.

It is preferred that the thermosetting resin composition of the the present invention be prepared by mixing the thermosetting resin(A), solvent if necessary, and the inorganic and/or organic fine particles(B) as filler, the fluorine-containing polyether(C) as surfactant, defoaming agent and curing accelerator, kneading the mixture and adding thereto curing agent to thereby produce a film-forming material. A protective film can be obtained by curing method where the material is applied on the surface by screen-printing or the like and subjected to drying/heating.

(A) Thermosetting resin

As thermosetting resin (A) usable in the present invention, any thermosetting resin generally used in resin composition for protective films can be employed. Examples thereof include epoxy-base resin, elastomer-modified epoxy-base resin, urethane resin, elastomer-modified urethane resin, polyimide resin, elastomer-modified polyimide resin and modified acrylic acid thereof. One of these resins may be used or two or more of them may be used in combination.

For epoxy-base resin, combination of epoxy resin and curing agent is generally employed.

Typical examples of epoxy resin include bisphenol A-type epoxy resin, bisphenol F-type epoxy resin, bisphenol S-type epoxy resin, phenol novolak epoxy resin, cresol novolak epoxy resin and epoxy resin such as alicyclic epoxy resin having two or more epoxy groups in one molecule.

Examples of curing agent include amines, imidazoles, acid anhydrides, phenols, quaternary ammonium salts and compounds containing a methyrol group.

Examples of urethane-base resin include polybutadiene diol-based polyurethane resins described in Japanese Patent Application Laid-Open Nos. 2000-186248 (US Patent No. 6,433,123) and H11-071551.

Examples of polyimide-base resin include polyamide imide resins described in Japanese Patent Application Laid-Open Nos.2001-302795, 2004-137370 and 2004-211055 and polyimide siloxanes described in Japanese Patent Application Laid-Open Nos.2004-169042 and 2004-211064.

Moreover, in a case where specific urethane resin containing a carboxyl group as described below is employed as thermosetting resin, a resin composition for protective film, well-balanced in electrical characteristics and flexibility after cured, can be obtained.

Such a carboxyl group-containing urethane can be synthesized by allowing the following materials at blending molar ratios as described later to react with each other.

(a) polyisocyanate compound,
(b) polyol compound and
(c) dihydroxy compound having a carboxyl group, further, if necessary
(d) monohydroxy compound and
(e) monoisocyanate compound.

(a) polyisocyanate compound

Specific examples of (a) polyisocyanate compound include diisocyanates such as 2,4-tolylene diisocyanate, 2,6-tolylene diisocyanate, isophorone diisocyanate, 1,6-hexamethylene diisocyanate, 1,3-trimethylene diisocyanate, 1,4-tetramethylene diisocyanate, 2,2,4-trimethylhexamethylene diisocyanate, 2,4,4-trimethylhexamethylene diisocyanate, 1,9-nonamethylene diisocyanate, 1,10-decamethylene diisocyanate, 1,4-cyclohexane diisocyanate, 2,2'-diethylether diisocyanate, diphenylmethane 4,4'-diisocyanate, (o, m, or p)-xylene diisocyanate, methylene-bis(4-cyclohexyl

isocyanate), cyclohexane-1,3-dimethylene diisocyanate, cyclohexane-1,4-dimethylene diisocyanate, 1,5-naphthalene diisocyanate, p-phenylene diisocyanate, 3,3'-methylene ditolylene-4,4'-diisocyanate, 4,4'-diphenylether diisocyanate, tetrachlorophenylene diisocyanate and norbornane diisocyanate. One of these diisocyanates can be used independently or two or more kinds thereof may be used in combination.

Generally, the polyisocyanate compound (a) has two isocyanate groups in one molecule. However, a small amount of polyisocyanate compound such as triphenylmethane triisocyanate having three or more isocyanate groups may be used within a range that polyurethane of the present invention does not gelate. Specifically, such a polyisocyanate may be used in an mount of 5 mol % or less based on the total amount of the isocyanate compounds.

Particularly among these polyisocyanate compounds, in a case where an alicyclic compound having 6 to 30 carbon atoms except for those included in isocyanate groups (NCO groups), the cured product of the present invention can exhibit most excellent long-term insulation reliability at a high temperature and a high humidity.

It is preferred that such an alicyclic compound be contained at a concentration of 10 mol % or more, more preferably 20 mol% or more, still more preferably 30 mol % or more based on the total amount of the polyisocyanate compounds (a) (100 mol %). Examples of the alicyclic compound include 1,4-cyclohexane diisocyanate, isophorone diisocyanate, methylene bis(4-cyclohexyl isocyanate), cyclohexanel,3-dimethylene diisocyanate and cyclohexane 1,4-dimethylene diisocyanate.

(b) Polyol compound

As polyol compound(b), one or more compounds selected from the group consisting of polycarbonate polypol, polyether polyol, polyester polyol, polylactone polyol, polybutadiene polyol, hydroxyl-terminated polysilicone (with both terminals hydroxylated) and polyol compound having 18 to 72 carbon atoms in its constituents and not containing oxygen except for oxygen present in hydroxyl group are used as raw material.

Polycarbonate polyol can be obtained by allowing diol having 4 to 18 carbon atoms as raw material to react with ester carbonate or phosgene. Specifically, such a compound is represented by the follwing structural formula.

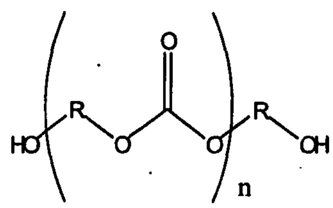

(In the formula, R is a residue after removing a hydroxyl group from the corresponding diol, and n is the number of repetition of the repeating unit.)

Examples of diol serving as raw material include 1,4-butane diol, 1,5-pentane diol, 1,6-hexane diol, 3-methyl-1,5-pentane diol, 1,8-octane diol, 1,3-cyclohexane dimethanol, 1,4-cyclohexane dimethanol, 1,9-nonane diol, 2-methyl-1,8-octane diol, 1,10-decamethylene glycol and 1,2-tetradecane diol.

As polycarbonate polyol, polycarbonate diol is particularly preferably used. The polycarbonate diol may be a polycarbonate diol (copolymer polycarbonate diol) having two or more kinds of alkylene groups in its skeleton. Using such a copolymer polycarbonate diol includes advantages in terms of prevention of crystallization of generated polyurethane in many cases. Moreover, in consideration for solubility into solvent, it is preferred that polycarbonate diol having a substituent on its side chain be partly used in combination.

As polyether polyol, those obtained by subjecting diol having 2 to 12 carbon atoms to dehydrating condensation or subjecting oxirane compound, oxetane compound or tetrahydrofuran compound having 2 to 12 carbon atoms to ring-opening polymerization are employed. Specifically, such a compound is represented by the following structural formula.

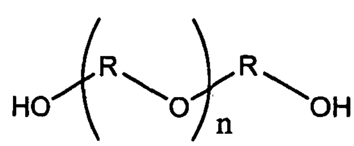

(In the formula, R is a residue after removing a hydroxyl group from the corresponding diol and n is the number of

repetition of the repeating unit.)

Examples thereof include polyethylene glycol, polypropylene glycol, poly-1,2-butylene glycol, polytetramethylene glycol and poly-3-methyltetramethylene glycol. In addition, copolymers of these compounds may be used for the purpose of enhancing compatibility and hydrophobicity.

As polyester polyol, those obtained by subjecting the following dicarboxylic acid and diol to dehydrating condensation or subjecting lower alcohol ester of dicarboxylic acid and diol to ester exchange reaction are used. Specifically, such a compound is represented by the following structural formula.

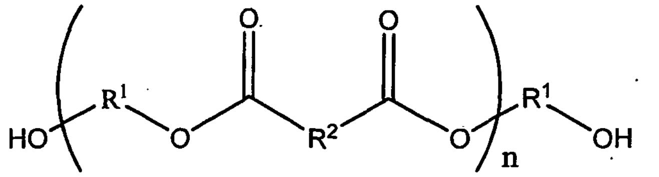

(In the formula, $R^1$ is a residue after removing a hydroxyl group from the corresponding diol, $R^2$ is a residue after removing a carboxyl group from the corresponding dicarboxylic acid and n is the number of repetition of the repeating unit.)

Specific examples of diol used for the synthesis of the polyester polyol include ethylene glycol, 1,2-propane diol, 1,3-propane diol, 1,2-butane diol, 1,3-butane diol, 1,4-butane diol, 1,5-pentane diol, 1,6-hexane diol, 3-methyl-1,5-pentane diol, 1,8-octane diol, 1,3-cyclohexane dimethanol, 1,4-cyclohexane dimethanol, 1,9-nonane diol, 2-methyl-1,8-octane diol, 1,10-decamethylene glycol or 1,2-tetradecane diol, 2,4-diethyl-1,5-pentand diol, butyl ethyl propane diol, 1,3-xylylene glycol, 1,4-xylylene glycol, diethylene glycol, triethylene glycol and dipropylene glycol.

In addition, examples of dicarboxylic acid used for the synthesis of the polyester polyol include succinic acid, glutaric acid, adipic acid, azelaic acid, sebacic acid, decanedicarboxylic acid, brassylic acid, 1,4-cyclohexanedicarboxylic acid, hexahydrophthalic acid, methyltetrahydrophthalic acid, endomethylenetetrahydrophthalic acid, methylendomethylene tetrahydrophthalic acid, chlorendic acid, fumaric acid, maleic acid, itaconic acid, citraconic acid, phthalic acid, isophthalic acid, terephthalic acid, 1,4-naphthalenedicarboxylic acid and 2,6-naphthalenedicarboxylic acid.

As polylactone polyol, those obtained through ring-opening polymerization between diol and lactone compound or through condensation reaction between diol and hydroxyalkanoic acid are used. Such a compound is represented by the following structural formula.

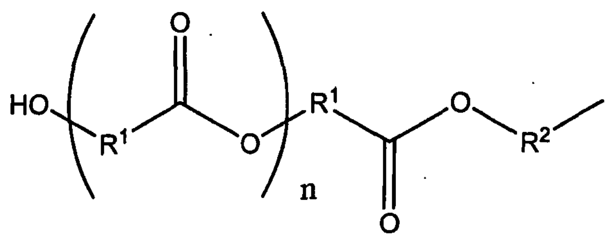

(In the formula, $R^1$ is a residue after removing a hydroxyl group and a carboxyl group from the corresponding hydroxyalkanoic acid, $R^2$ is a residue after removing a hydroxy group from the corresponding diol and n is the number of repetition of the repeating unit.)

Examples thereof include 3-hydroxy butanoic acid, 4-hydroxy pentanoic acid and 5-hydroxyhexanoic acid (ε-caprolactone).

As polybutadiene polyol, those obtained by polymerizing butadiene or isoprene through anionic polymerization and introducing hydroxyl groups to both terminals through treatment for terminals can be used and also compounds obtained by subjecting a double bond of these compounds to hydrogen reduction can be used.

Examples thereof include hydroxylated polybutadiene mainly having 1,4-repeating unit (such as Poly bd R-45HT, Poly bd R-15HT(manufactured by Idemitsu Kosan Co., Ltd.)), hydroxylated polybutadiene(such as polytail H and polytail HA (manufactured by Mitsubishi Chemical Corp.)), hydroxylated polybutadiene mainly having 1,2-repeating unit (such as G-1000,G-2000,G-3000(manufactured by NIPPON SODA CO., LTD.)), hydroxylated hydrogenated polybutadiene(such as GI-1000,GI-2000,GI-3000) manufactured by NIPPON SODA CO., LTD.)), hydroxyl-terminated polyisoprene (such as Poly IP(manufactured by Idemitsu Kosan Co., Ltd.)) and hydrogenated polyisoprene(such as Epol (manufactured by Idemitsu Kosan Co., Ltd.)).

Hydroxyl-terminated polysilicone is represented by the following structural formula.

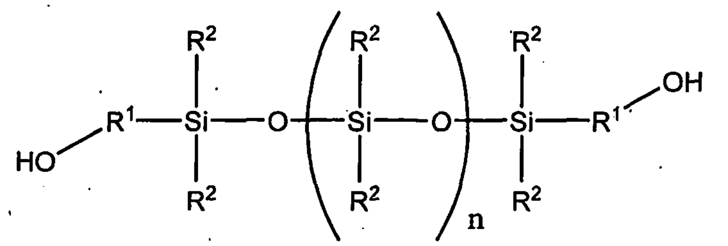

(In the formula, $R^1$ represents an aliphatic hydrocarbon group or aromatic hydrocarbon group having 2 to 50 carbon atoms, which may contain an ether group; $R^2$ and $R^3$ each independently represents an aliphatic hydrocarbon group or aromatic hydrocarbon group having 1 to 12 carbon atoms and n is the number of repetition of the repeating unit.)

Examples of commercially available product include X-22-160AS, KF6001, KF6002 and KF-6003 mannufactured by Shin-etsu Chemical Co., Ltd.

Examples of polyol compound not containing oxygen except for oxygen present in hydroxyl groups and havins 18 to 72 carbon atoms in its constituent components include diol compounds having a skeleton with hydrogenated dimer acid, and examples of commercially available products include Sovermo 1908 manufactured by Cognis.

Further, as other polyol compound (d), diols having a molecular weight of 300 or less may also be used within a range which does not impair physical properties. Specific examples of such diols having a low molecular weight include ethylene glycol, 1,2-propanediol, 1,3-propanediol, 1,2-butanediol, 1,3-butanediol, 1,4-butanediol, 1,5-pentanediol, 1,6-hexanediol, 3-methyl-1,5-pentanediol, 1,8-octanediol, 1,3-cyclohexane dimethanol, 1,4-cyclohexane dimethanol, 1,9-nonane diol, 2-methyl-1,8-octane diol, 1,10-decamethylene glycol, 1,2-tetradecane diol, 2,4-diethyl-1,5-pentane diol, butyl ethyl propane diol, 1,3-xylylene glycol, 1,4-xylylene glycol, diethylene glycol, triethylene glycol and dipropylene glycol.

(c) Carboxyl group-containing dihydroxy compound

Examples of carboxyl group-containing dihydroxy compound (c) include 2,2-dimethylol propionic acid, 2,2-dimethylol butanoic acid, N,N-bishydroxyethyl glycine and N,N-bishydroxyethyl alanine. Particlularly preferred among these are 2,2-dimethylol propionic acid, 2,2-dimethylol butanoic in the light of solubility into solvent. One of these carboxyl group-containing dihydroxy compounds may be used singly or two or more of them may be used in combination.

Although the carboxyl group-containing polyurethane of the present invention can be synthesized only from the above three components (a), (b) and (c), the compound may be synthesized by further allowing monohydroxy compound (d) and/or monoisocyanate compound (e) for the purpose of imparting radical polymerizability or cationic polymerizability to the polyurethane or eliminating influence of isocyanate residue or hydroxyl group at terminals of the polyurethane.

(d) monohydroxy compound

As (d) monohydroxy compound used for the purpose of imparting a radical polymerization property or a cationic polymerization property, a compound having a radically polymerizable double bond or a cationic polymerizable functional group is preferred. Examples of the former compound having a radically polymerizable double bond include 2-hydroxyethyl (meth)acrylate, hydroxypropyl (meth)acrylate, hydroxybutyl (meth)acrylate, cyclohexanedimethanol mono(meth) acrylate, a caprolactone or an alkylene oxide-adduct of any one of these (meth)acrylates, glycerin di(meth)acrylate, trimethylol propane di(meth)acrylate, pentaerythritol tri(meth)acryalate, dipentaerythritol penta(meth)acrylate, ditrimethylolpropane tri(meth)acrylate, allyl alcohol, allyloxyethanol, 1,4-butanediol monovinylether and cyclohexane dimethanol monovinylether. Meanwhile, examples of the latter compound having a cationic polymerizable functional group include a compound having hydroxyl group and carboxyl group. In particular, glycolic acid, hydroxypivalic acid, lactic acid, malic acid, citric acid, 2-hydroxyethylpropionic acid and hydroxyisobutyric acid are cited.

One of these monohydroxy compounds may be used independently or two or more kinds thereof may be used in combination. Further, among these compounds, 2-hydroxyethyl (meth)acrylate, hydroxypropyl (meth)acrylate, hydroxybutyl (meth)acrylate, allyl alcohol, glycolic acid, and hydroxypivalic acid are preferred and 2-hydroxyethyl (meth) acrylate is more preferred.

In addition to the monohydroxy compounds above, examples of the monohydroxy compound (d) to be added for the purpose of eliminating the influence of the terminal isocyanate residue include low molecular weight alcohols such as methanol, ethanol, n-propanol, isopropanol, n-butanol, isobutanol, sec-butanol, t-butanol, amyl alcohol, hexyl alcohol and octyl alcohol.

(e) monoisocyanate compound

Examples of (e) monoisocyanate compound include those having a radically polymerizable double bond such as (meth)acryloyloxyethyl isocyanate, 2-hydroxyethyl (meth)acrylate for diisocyanate compound, hydroxypropyl (meth) acrylate, hydroxybutyl (meth)acrylate, cyclohexanedimethanol mono(meth)acrylate, a caprolactone or an alkylene oxide-adduct of any one of these (meth)acrylates, glycerin di(meth)acrylate, trimethylolpropane di(meth)acrylate, pentaerythritol tri(meth)acryalte, dipentaerythritol penta(meth)acrylate, ditrimethylolpropane tri(meth)acrylate, allyl alcohol and a mono-adduct of allyloxyethanol.

Examples of monoisocyanate hydroxyl compound used for the purpose of eliminating influence of hydroxy residue at terminals include phenyl isocyanate, hexyl isocyanate and dodecyl isocyanate.

It is preferable that the carboxyl group-containing polyurethane of the present invention have a number average molecular weight of 1000 to 100000, more preferably 3000 to 50000. The molecular weight referred to here is a value measured by gel permeation chromatography (GPC) in terms of styrene. If the molecular weight is less than 1000, degree of elongation, flexibility and strength of cured film may be decreased. If the molecular weight exceeds 100000, solubility into solvent decreases and even if the polyurethane can dissolve in solvent, viscosity of the solution will be too high, which causes much inconvenience in use.

In the present Specification, the measuring conditions in gel permeation chromatography (GPC) are as follows unless otherwise specified.

Apparatus Name: HPLC unit HSS-2000 manufactured by JASCO CORPORATION
Column: Shodex column LF-804
Mobile phase: tetrahydrofuran
Flow rate: 1.0mL/min
Detector: RI-2031Plus manufactured by JASCO CORPORATION
Temperature: 40.0 ˚C
Sample amount: sample loop 100 μl
Concentration of sample: adjusted to be around 0.1 wt%

It is preferable that the carboxyl group-containing polyurethane of the present invention have the present invention have an acid value of 5 to 120mg-KOH/g, more preferably 10 to 70mg-KOH/g. If the acid value is less than 5mg-KOH/g, reactivity with other curable resins such as epoxy resin, which may lead to decrease in heat resistance. If the acid value exceeds 120mg-KOH/g, the cured film may become too hard and fragile.

The acid value of resin in the present Specification was measured by the following method.

About 0.2 g of sample was weighed by a precision balance and placed in a 100ml-Erlenmeyer flask. Thereto, 10 ml of a mixed solvent of ethanol/toluene=1/2(mass ratio) is added to dissolve the sample. Then, 1 to 3 drops of phenol phthalein solution were added thereto as indicator and the resultant solution was stirred enough for the sample to be uniformly dissolved. This was titrated with 0.1N potassium hydroxide-ethanol solution and the time point when a slight red hue of the indicator continued for 30 seconds was determined as completion of neutralization. The acid value of resin was calculated from the result by using the following calculating formula.

$$\text{Acid value (mg-KOH/g)} = [B \times f \times 5.611] / S$$

B: use amount of 0.1N potassium hydroxide-ethanol solution(ml)
f: factor of 0.1N potassium hydroxide-ethanol solution and in this case, f=1
S: sample amount taken out(g)

The carboxyl group-containing polyurethane of the present invention can be synthesized by allowing polyisocyanate (a), polycarbonate diol(b), dihydroxy compound(c), and if necessary, monohydroxy compound (d), monoisocyanate compound(e) to react with an appropriate sovent in the presence or absence of known urethanizing catalyst such

as dibutyl tin dilaurylate. It is preferable that the Synthesis be conducted by reaction without catalyst, so that the final property values of cured film in actual use can be enhanced.

As the aforementioned organic solvents, those having low reactivity with isocyanate can be used, and those which does not have a basic functional group such as amine and those having a boiling point of 110˚C or more, especially 200˚C or more, are preferably used. Examples of such organic solvents include toluene, xylene, ethylbenzene, nitrobenzene, cyclohexane, isophorone, diethyleneglycol dimethylether, ethyleneglycol diethylether, propyleneglycol methyletheracetate, propyleneglycol ethyletheracetate, dipropyleneglycol methyletheracetate, diethyleneglycol ethyletheracetate, methyl methoxypropionate, ethyl methoxypropionate, methyl ethoxypropionate, ethyl ethoxypropionate, ethyl acetate, n-butyl acetate, isoamyl acetate, ethyl lactate, acetone, methyl ethyl ketone, cyclohexanone, N,N-dimethylformamide, N,N-dimethylacetamide, N-methylpyrrolidone, γ-butyrolactone, dimethyl sulfoxide, chloroform and methylene chloride.

Particularly preferred amoung the above examples in consideration that an oganic solvent with which the generated carboxyl group-containig polyurethane has low solubility is not preferred and that the polyurethane is used as raw material for ink in electronic materials are propyleneglycol methylether acetate, propyleneglycol ethylether acetate, dipropyleneglycol methylether acetate, diethyleneglycol ethylether acetate and γ-butyrolactone.

The order in which the raw materials are blended in is not particularly limited. Generally, polycarbonate diol(b) and dihydroxy compound(c) are the first to be blended in and dissolved in solvent. Then at a temperature of 20 to 150 ˚C, more preferably at a temperature of 60 to 120 ˚C, diisocyanate compound (a) is added thereto dropwise and subsequently, at a temperature of 30 to 160 ˚C, more preferably at a temperature of 50 to 130 ˚C.

The molar ratio of the blended raw materials is adjusted according to the molecular weight and acid value of the polyurethane to be synthesized. In a case where monohydroxy compound (d) is introduced into the polyurethane, diisocyanate compound (a) has to be used in an amount equal to or more excessively than the amounts of polycarbonate diol(b) and dihydroxy compound(c) (the total number of isocyanate groups has to be larger than that of hydroxyl groups), so that the terminals of the polyurethane molecules can be isocyanate groups.

Specifically, it is preferable that the blending ratio by mol of diisocyanate compound (a):(polycarbonate diol(b) + dihydroxy compound(c)) be from 0.5 to 1.5:1, more preferably from 0.8 to 1.2:1. Moreover, it is preferable that the blending ratio by mol of polycarbonate diol(b):dihydroxy compound(c) be 1:from 0.1 to 30, more preferably 1:from 0.3 to 10.

In a case where monohydroxy compound (d) is used, it is preferable that the number of moles of diisocyanate compound (a) be equal to or more excessive than that of polycarbonate diol(b) + dihydroxy compound (c) and that monohydroxy compound (d) be used in a molar amount from 0.5 to 1.5 times larger, more preferably from 0.8 to 1.2 times larger, based on the excessive number of moles of NCO groups.

In a case where monoisocyanate compound (e) is used, it is preferable that the number of moles of polycarbonate diol(b) + dihydroxy compound(c) be more excessive than that of diisocyanate compound(a) and that monoisocyanate compound (e) be used in a molar amount from 0.5 to 1.5 times larger, more preferably from 0.8 to 1.2 times larger, based on the excessive number of moles of hydroxy groups.

In order for the monohydroxy compound (d) to be introduced into the polyurethane, monohydroxy compound (d) is added dropwise to the polyurethane solution at a temperature of 20-150 ˚C, preferably at a temperature of 70 to 120 ˚C at the time point when reaction among the polycarbonate diol(b), the dihydroxy compound(c) ahd the diisocyanate (a) is almost completed, to thereby allow isocyanate groups remaining at terminals of polyurethane with the monohydroxy compound(d), and the reaction mixture is kept at the same temperature to thereby comlete the reaction.

In order for the monoisocyanate compound (e) to be introduced into the polyurethane, monoisocyanate compound(e) is added dropwise to the polyurethane solution at a temperature of 20-150 ˚C, preferably at a temperature of 50 to 120 ˚C at the time point when reaction among the polycarbonate diol(b), the dihydroxy compound(c) and the diisocyanate(a) is almost completed, to thereby allow hydroxy groups remaining ant both terminals of polyurethane with the monoisocyanate compound(e), and the reaction mixture is kept at the same temperature to thereby comlete the reaction.

(B) Inorganic or organic fine particles (fillers)

With respect to inorganic or organic fine particles, any known product can be used. The blending ratio varies depending on the thermosetting resin used. Generally, in case of adding such particles, it is preferred that the amount of the particles be within a range of 10 to 40 mass % based on the total amount of the resin composition.

Examples of organic filler include epoxy resin powder, melamine resin powder, urea resin powder, guanamine resin powder, polyester resin powder and silicone powder. Examples of inorganic filler include silica, alumina, titanium oxide, barium sulfate, talc, carcium carbonate, glass powder and quartz powder.

(C) Fluorine-containing polyether(surfactant)

The thermosetting resin composition of the present invention is a composition containing as surfactant a polymer having a fluorinated alkyl polyoxetane structure represented by the following formula (1) or (2) or a copolymer consisting of monomer having the fluorinated alkyl polyoxetane structure and oxygen-containing monomer having 2 to 6 carbon atoms.

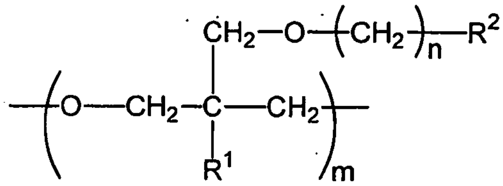

(1)

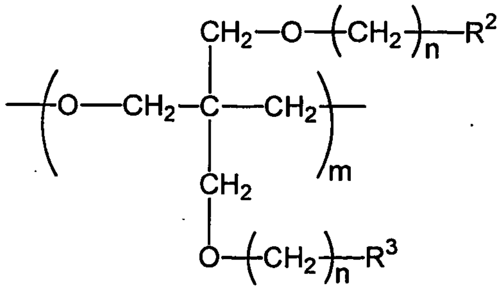

(2)

(In the formula, m represents an integer of 1 to 100, n represents an integer of 1 to 6, $R^1$ represents a hydrogen atom or an alkyl group having 1 to 6 carbon atoms, $R^2$ and $R^3$ each independently represents a straight-chain or branched-chain alkyl group having 1 to 20 carbon atoms and at least 50 % of hydrogen atoms in the alkyl groups is substituted by fluorine atoms and the other hydrogen atom are substituted by hydrogen atoms, iodine atomes, chlorine atoms or bromine atoms.)

It is preferable that at least 50 % of hydrogen atoms present in the alkyl group represented by $R^2$ or $R^3$ be substituted by fluorine atoms, more preferably 75 % or more, most preferably 95 % or more. If the amount of substitution by fluorine atoms is too small, leveling and defoaming properties as desired cannot be obtained.

If a chain of the alkyl group represented by $R^2$ or $R^3$ is too long, defoaming effect as desired may not be exhibited. Therefore, the number of carbon atoms in an alkyl group represented by $R^2$ or $R^3$ is 20 or less, preferably 7 or less, more preferably 3 or less. For the same reason, n in the formula is 6 or less, preferably 3 or less, more preferably 1.

In the formula, m is preferably from 2 to 100, more preferably from 2 to 30. If the molecular weight of polyether is too small, the polyether can not exibit its property as surfactant and also bleeding may occur. On the contrary, if the molecular weight is too large, the polyether can not exibit its property as surfactant and also may form agglomeration to become like a foreign substance.

The number average moleacular weight of fluorine-containing polyether(C) is preferably from about 300 to about 10000, more preferably from 1000 to 8000.

[Polymer having a fluorinated alkyl polyoxetane structure]

As polymer having a fluorinated alkyl polyoxetane structure represented by formula (1) or (2), any commercially available product may be used or the compound may be synthesized according to any known method regarding polyether compound. Examples of commercially available product include PolyFOX PF656 (manufactured by Omnova Solutions, Inc.) (compound of formula (1) wherein m=6, n=1, $R^1$=$CH_3$ and $R^2$=$C_2 F_5$), PolyFOX PF636(manufactured by Omnova Solutions, Inc.)(compound'of formula (1) wherein m=6, n=1 and $R^1$=$R^2$=$CH_3$), PolyFOX PF6320(manufactured by Omnova Solutions, Inc.)(compound of formula (1) wherein m=20, n=1 and $R^1$=$R^2$=$CH_3$) and PolyFOX PF6520(manufactured by Omnova Solutions, Inc.)(compound of formula (1) wherein m=20, n=1, $R^1$ =$CH_3$ and $R^2$ =$C_2 F_5$).

Alternatively, such a compound can be synthesized by polymerising cyclic ether represented by either of the following formulae in the presence of Lewis catalyst such as trifluoroborane complex (e.g., trifluoroborane etherate and

trifluoroborane tetrahydrofuran(THF)), phosphorus pentafluoride, antimony pentafluoride, zinc chloride and aluminium bromide and in the presence of inert solvent.

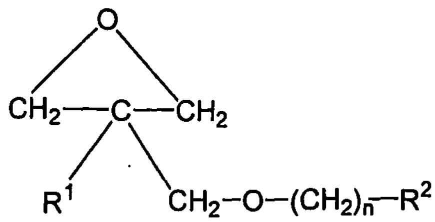

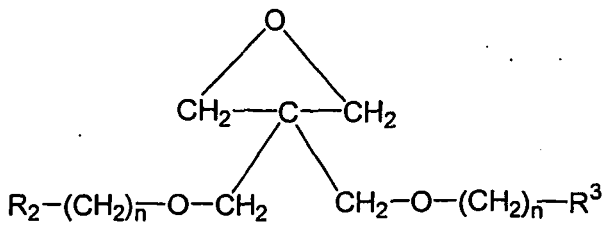

(In the formulae, the meanigs of n and $R^1$ and $R^3$ are the same as shown above.)
The inert solvent is generally a hydrocarbon having 1 to about 6 carbon atoms or a halogenated solvent. Examples thereof include methylene chloride, carbon tetrachloride, trichloroethylene, chlorobenzene and dichloroethane (see for example, Japanese Patent Application Laid-Open No. 2004-535485 (PCT Publication No. WO 2002/092660)).

The polymer having a fluorinated alkyl polyoxetane structure represented by formula (1) or (2) may be a homopolymer consisting only of repeating unit represented by either of the formulae, a copolymer consisting of mixture of the repeating units or a copolymer consisting of monomer having either of these repeating unit and oxygen-containing monomer having 2 to 6 carbon atoms. Examples of such a copolymer include copolymer of epoxy compound, oxetane compound and/or tetrahydrofuran derivative with fluorooxetane.

Examples of the monomer having 2 to 6 carbon atoms containing oxygen atom include mono or poly hydroxylalcohol having 2 to 6 carbon atoms in the molecule or cyclic ether. Specific examples of the mono or poly hydroxylalcohol include ethylene glycol, butane-1,4-diol, propylene glycol, isobutane-1,3-diol, pentane-1,5-diol, pentaerythritol and trimethylolpropane; or ethanol. These monomers can be contained in the above-mentioned copolymer as oligomer or polymer. Examples of such oligomers or polymers include diethylene glycol, polyethylene glycol and polypropylene glycol. Meanwhile, examples of the cyclic ether include epoxy compound, oxetane compound and tetrahydrofuran derivatives. These cyclic ethers may have substituents such as alkyl, fluorine and other halogen atoms on the carbon atoms structuring the ring.

[Blending ratio]

The thermosetting resin composition of the present invention is charactarized in that it contains thermosetting resin as components (A), inorganic fine particles and/or organic fine particles as component (B) and fluorine-containing polyether as component (C) at the following blending ratios based on the total amount of the thermosetting resin composition:

(A) thermosetting resin: from 20 to 90 mass%,
(B) inorganic fine particles and/or organic fine particles: from 10 to 80 mass%, and
(C) fluorine-containing polyether: from 0.1 to 5mass%, preferably,
(A) thermosetting resin: from 40 to 90 mass%,
(B) inorganic fine particles and/or organic fine

particles: from 10 to 60 mass%, and

(C) fluorine-containing polyether: from 0.1 to 5 mass%, more preferably,
(A) thermosetting resin: from 60 to 85 mass%,
(B) inorganic fine particles and/or organic fine particles: from 10 to 40 mass%, and
(C) fluorine-containing polyether: from 0.1 to 5 mass%.

Moreover, the thermosetting resin composition of the present invention can be used for various uses other than used as overcoating agent for flexible circuit boards. For example, in a case where the composition is used in a heat-releasing member, it is preferable that the composition contain the components at the following ratios.

(A) thermosetting resin: from 20 to 50 mass%,
(B) inorganic fine particles and/or organic fine particles: from 50 to 80 mass%, and
(C) fluorine-containing polyether: from 0.1 to 5 mass%.

[Curing agent]

As curing agent, those capable of curing carboxyl group-containing polyurethane can be used and among those, epoxy resin is preferred.

Example of epoxy resin include epoxy compounds having two or more epoxy groups in one molecule such as bisphenol A type epoxy resin, hydrogenated bisphenol A type epoxy resin, brominated bisphenol A-type epoxy resin, bisphenol F-type epoxy resin, hydrogenated bisphenol F-type epoxy resin, novolak type epoxy resin, phenol-novolak type epoxy resin, cresol novolak type epoxy resin, alicyclic epoxy resin, N-glycidyl type epoxy resin, novolaktypeepoxy resin of bisphenol A, chelate type epoxy resin, glyoxal type epoxy resin, amino group-containing epoxy resin, rubber-modified epoxy resin, dicyclopentadiene phenolic-type epoxy resin, silicone-modified epoxy resin and ε-caprolactone modified epoxy resin. Particularly preferred among these is alicyclic epoxy compound.

In addition, for the purpose of imparting flame retardancy to the composition, those having halogen atoms such'as chlorine and bromine or other atoms such as phosphor introduced in the srtucture may be used. Further, resins such as bisphenol S type epoxy resin, diglycidylphthalate resin, heterocyclic epoxy resin, bixylenol type epoxy resin, biphenol type epoxy resin and tetraglycidyl xylenoyl ethane resin may be used.

It is preferable that the epoxy resin having two or more epoxy groups be contained. However, epoxy resin having only one epoxy group may also be used.

[Solvent]

It is preferable that the thermosetting resin composition of the present invention contain solvent.

It is more preferable that the solvent contained in state that the thermosetting resin is dissoved therein. It is particularly preferable that the thermosetting resin be in a state of being dissolved in the solvent used in synthesizing the composition.

In a case where the thermosetting resin composition is to be obtained as solid product through synthesis, it is difficult to disperse the thermosetting resin without using solvent and the process for dissolving the solid product in solvent after the synthesis is required. Therefore, it is economically disadvantageous.

There is no particular limitation on solvent to be used as long as the solvent can dissolve the thermosetting resin. It is preferable that the boiling point of the solvent used be from 30 to 400˚C, more preferably 110 to 300 ˚C.

Examples of the solvents include toluene, xylene, ethylbenzene, nitrobenzene, cyclohexane, isophorone, diethyleneglycol dimethylether, ethyleneglycol diethylether, carbitol acetate, propyleneglycol methyletheracetate, propyleneglycol ethyletheracetate, dipropyleneglycol methyletheracetate, diethyleneglycol ethyletheracetate, methyl methoxypropionate, ethyl methoxypropionate, methyl ethoxypropionate, ethyl ethoxypropionate, ethyl acetate, n-butyl acetate, isoamyl acetate, ethyl lactate, acetone, methyl ethyl ketone, cyclohexanone, N,N-dimethylformamide, N,N-dimethylacetamide, N-methylpyrrolidone, γ-butyrolactone, dimethyl sulfoxide, chloroform and methylene chloride.

It is preferable that the solvent be added in such an amount that the concentration (solid concentration) of carboxyl group-containing polyurethane in the thermosetting resin composition be from 10 to 90 mass%, more preferably from 30 to 80 mass %.

[Defoaming agent]

As defoaming agent, other non-silicon-based defoaming agents may be used to supplement fluorine-based surfactant. One of these agents may be used singly or two or more of them may be used in combination. There is no particular limitation on the blending amount and ratio and the amount and ratio can be appropriately adjusted according to the degrees of involving foams and of defoamability at the time of screen printing. As such a non-silicone based

defoaming agent, BYK-A500(product name, manufactured by BYK Chemie Japan K K), BYK-A501 (product name, manufactured by BYK Chemie Japan K K), BYK-A515 (product name, manufactured by BYK Chemie Japan K K) or BYK-A555 (product name, manufactured by BYK Chemie Japan K K) can be preferably used.

[curing promoter]

Examples of curing promoters include known and conventional curing agents or curing promoters such as imidazole derivatives such as 2MZ, 2E4MZ, C11Z, C17Z, 2PZ, 1B2MZ, 2MZ-CN, 2E4MZ-CN, C11Z-CN, 2PZ-CN, 2PHZ-CN, 2MZ-CNS, 2E4MZ-CNS, 2PZ-CNS, 2MZ-AZINE, 2E4MZ-AZINE, C11Z-AZINE, 2MA-OK, 2P4MHZ, 2PHZ, and 2P4BHZ (all trade names) produced by Shikoku Chemicals Corp.; guanamines such as acetoguanamine and benzoguanamine; polyamines such as diaminodiphenylmethane, m-phenylenediamine, m-xylenediamine, diaminodiphenyl sulfone, dicyandiamide, urea, urea derivatives, melamine and polybasic hydrazides; organic acid salts thereof and/or epoxy adducts thereof; amine complexes of boron trifluoride; triazine derivatives such as ethyldiamino-S-triazine, 2,4-diamino-S-triazine and 2,4-diamino-6-xylyl-S-triazine; amines such as trimethylamine, triethanolamine, N,N-dimethyloctylamine, N-benzyldimethylamine, pyridine, N-methylmorpholine, hexa (N-methyl)melamine, 2,4,6-tris(dimethylaminophenol), tetramethylguanidine, and m-aminophenol; polyphenols such as polyvinylphenol, brominated polyvinylphenol, phenolic novolak and alkylphenolic novolak; organophosphines such as tributylphosphine, triphenylphosphine, and tris-2-cyanoethylphosphine; phosphonium salts such as tri-n-butyl-(2,5-dihydroxyphenyl)phosphonium bromide and hexadecyltributylphosphonium chloride; quaternary ammonium salts such as benzyltrimethylammohium chloride and phenyltributylammonium chloride; anhydrides of the aforementioned polybasic acids; photo-cationic polymerization catalysts such as diphenyliodonium tetrafluoroborate, triphenylsulfonium hexafluoroantimonate, 2,4,6-triphenylthiopyrilium hexafluorophosphate, IRGACURE 261 produced by CIBA-GEIGY Japan Ltd. and OPTOMER SP-170 produced by Asahi Denka Kogyo K.K.; a styrene-maleic anhydride resin; and equimolar reaction products of phenyl isocyanate with dimethylamine and of an organic polyisocyanate such as tolylene diisocyanate or isophorone diisocyanate with dimethylamine.

[Other additives]

Morerover, in the thermosetting resin composition, various known additives, e.g., fiber reinforcement materials such as glass fiber, carbon fiber and boron nitride fiber, colorants such as titanium oxide, zinc oxide, carbon black, iron black, organic pigment and organic dye, antioxidants such as hindered phenol-bases compound, phosphorus compound and hindered amine-based compound, UV absorbents such as benzotriazole-based compound and benzophenone-based compound, may be'blended in.

Additionally, according to the use, viscosity adjusting agent, flame retardant, antibacterial agent, fungicide, antiaging agent, antistatic agent, plasticizer, lubricant, foaming agent or the like may be added and mixed in to the composition.

As method for kneading the above mixture, the added materials are dissolved or dispersed by use of disperser, kneader, three-roll mill, beads mill, homogenizer or the like.

The thus obtained cured product of the present invention is excellent in defoaming and leveling properties without using silicone-based defoaming agent, and also excellent in low warpage property, flexibility, plating resistance, soldering heat resistance, and long-term reliable insulating property.

Furthermore, the present invention includes overcoating agent containing the above thermosetting resin composition for flexible circuit boards, surface protective film comprising the overcoating agent, ink for permanently-insulating surface protective film, cured product obtained by curing the ink for permanently-insulating surface protective film and electronic components containing the cured product.

## EXAMPLES

The present invention is further described below by referring to Synthesis Examples and Examples, however, the present invention is by no means limited to the Examples.

Synthesis Example 1

In a reaction vessel equipped with a stirrer, a thermometer and a condenser, 660.6 g (0.69 mol) of C-1015N (manufactured by KURARAY CO., LTD, polycarbonate diol, molar ratio of raw material diols = 1,9-nonanediol:2-methyl 1,8-octanediol=15:85, molecular weight=964) and 73.39 g (0.05 mol) of G-1000(manufactured by NIPPON SODA CO., LTD., hydroxyl-terminated 1,2-polybutadiene, molecular weight=1548) as polyol compound (b), 138.4 g (0.93 mol) of 2,2-dimethylol butanoic acid (manufactured by Nippon Kasei Chemical Co., Ltd.) as carboxyl group-containing dihydroxyl compound(c) and 1303 g of diethyleneglycol ethylether acetate (manufactured by DAICEL CHEMICAL INDUSTRIES,

LTD.) as solvent were placed, and 2,2-dimethylol butanoic acid was dissolved therein at 90 ˚C. The temperature of the reaction solution was decreased to 70˚C and 437.3 g (1.67 mol) of Desmodule-W (manufactured by Sumika Bayer Urethane Co., Ltd.) as polyisocyanate (a) was added thereto dropwise through a dripping funnel over 30 minutes. After completion of the dripping, reaction was carried out at 80 ˚C for an hour, at 100˚C for an hour, and at 120 ˚C for 2 hours. After confirming that almost all the isocyanate disappeared, 5 g (0.07 mol) of isobutanol as monohydroxy compound (d) (manufactured by Wako Pure Chemical Industries, Ltd) was added dropwise and reaction was carried out at 120˚C for 1.5 hours.

The obtained carboxyl group-containing polyurethane had a number average molecular weight of 13800, and the acid value of the solid part was 40.2 mg-KOH/g.

Synthesis Example 2

In a reaction vessel equipped with a stirrer, a thermometer and a condenser, 1172 g (0.76 mol) of G-1000 (manufactured by NIPPON SODA CO., LTD., hydroxyl-terminated 1,2-polybutadiene, molecular weight=1548) as polyol compound (b), 172 g (1.16 mol) of 2,2-dimethylol butanoic acid (manufactured by Nippon Kasei Chemical Co., Ltd.) as carboxyl group-containing dihydroxyl compound(c) and 1744 g of diethyleneglycol ethylether acetate (manufactured by DAICEL CHEMICAL INDUSTRIES, LTD.) as solvent were placed, and all the materials were dissolved therein at 90 ˚C. The temperature of the reaction solution was decreased to 70 ˚C and 504 g (1.92 mol) of Desmodule-W (manufactured by Sumika Bayer Urethane Co., Ltd.) as polyisocyanate (a) was added thereto dropwise through a dripping funnel over 30 minutes. After completion of the dripping, reaction was carried out at 80˚C for 3 hours, at 90˚C for 3 hours, and at 100 ˚C for 3 hours. After confirming that almost all the isocyanate disappeared, 4.4 g (0.06 mol) of isobutanol as monohydroxy compound (d)(manufactured by Wako Pure Chemical Industries, Ltd.) was added dropwise and reaction was carried out at 100˚C for 1.5 hours.

The obtained carboxyl group-containing polyurethane had a number average molecular weight of 7800, and the acid value of the solid part was 35.0 mg-KOH/g.

Synthesis Example 3

In a reaction vessel equipped with a stirrer, a thermometer and a condenser, 70.7 g (0.07 mol) of C-1065N (manufactured by KURARAY CO., LTD, polycarbonate diol, molar ratio of raw material diols = 1,9-nonanediol:2-methyl 1,8-octanediol=65:35, molecular weight=991) as polyol compound (b), 13.5 g (0.09 mol) of 2,2-dimethylol butanoic acid (manufactured by Nippon Kasei Chemical Co., Ltd.) as carboxyl group-containing dihydroxyl compound(c) and 128.9 g of γ-butyrolactone (manufactured by Mitsubishi Chemical Corporation) as solvent were placed, and all the materials were dissolved at 90˚C. The temperature of the reaction solution was decreased to 70 ˚C and 42.4 g (0.16 mol) of Desmodule-W (manufactured by Sumika Bayer Urethane Co., Ltd.) as polyisocyanate (a) was added thereto dropwise through a dripping funnel over 30 minutes. After completion of the dripping, reaction was carried out at 80˚C for an hour, at 90 ˚C for an hour, and at 100 ˚C for 2 hours. After confirming that almost all the isocyanate disappeared, 1.46 g (0.015 mol) of isobutanol as monohydroxy compound (d)(manufactured by Wako Pure Chemical Industries, Ltd) was added dropwise and reaction was carried out at 105˚C for 1.5 hours.

The obtained carboxyl group-containing polyurethane had a number average molecular weight of 6800, and the acid value of the solid part was 39.9 mg-KOH/g.

Synthesis Example 4

In a reaction vessel equipped with a stirrer, a thermometer and a condenser, 305.0 g (0.16 mol) of C-2015N (manufactured by KURARAY CO., LTD, polycarbonate diol, molar ratio of raw material diols = 1,9-nonanediol:2-methyl 1,8-octanediol=15:85, molecular weight=1945) as polyol compound (b), 52.4 g (0.35 mol) of 2,2-dimethylol butanoic acid (manufactured by Nippon Kasei Chemical Co., Ltd.) as carboxyl group-containing dihydroxyl compound(c) and 494.9 g of diethyleneglycol ethylether acetate (manufactured by DAICEL CHEMICAL INDUSTRIES, LTD.) as solvent were placed, and all the materials were dissolved at 90 ˚C. The temperature of the reaction solution was decreased to 70˚C and 133.8 g (0.51 mol) of Desmodule-W (manufactured by Sumika Bayer Urethane Co., Ltd.) as polyisocyanate (a) was added thereto dropwise through a dripping funnel over 30 minutes. After completion of the dripping, reaction was carried out at 80˚C for an hour, at 90 ˚C for an hour, and at 100˚C for 1.5 hours. After confirming that almost all the isocyanate disappeared, 3.92 g (0.05 mol) of isobutanol as monohydroxy compound (d)(manufactured by Wako Pure Chemical Industries, Ltd) was added dropwise and reaction was carried out at 105˚C for 2 hours.

The obtained carboxyl group-containing polyurethane had a number average molecular weight of 9080, and the acid value of the solid part was 40.1 mg-KOH/g.

Synthesis Example 5

In a reaction vessel equipped with a stirrer, a thermometer and a condenser, 805.4 g (0.84 mol) of C-1015N (manufactured by KURARAY CO., LTD, polycarbonate diol, molar ratio of raw material diols = 1,9-nonanediol:2-methyl 1,8-octanediol=15:85, molecular weight=964) as polyol compound (b), 104.2 g (0.70 mol) of 2,2-dimethylol butanoic acid (manufactured by Nippon Kasei Chemical Co., Ltd.) as carboxyl group-containing dihydroxyl compound(c) and 1307 g of diethyleneglycol ethylether acetate (manufactured by DAICEL CHEMICAL INDUSTRIES, LTD.) as solvent were placed, and all the materials were dissolved at 90˚C. The temperature of the reaction solution was decreased to 70 ˚C and 403.6 g (1.54 mol) of Desmodule-W (manufactured by Sumika Bayer Urethane Co., Ltd.) as polyisocyanate (a) was added thereto dropwise through a dripping funnel over 30 minutes. After completion of the dripping, reaction was carried out at 80˚C for an hour, at 100˚C for an hour, and at 120 ˚C for 2 hours. After confirming that almost all the isocyanate disappeared, 5.7 g (0.08 mol) of isobutanol as monohydroxy compound (d)(manufactured by Wako Pure Chemical Industries, Ltd) was added dropwise and reaction was carried out at 125 ˚C for 1.5 hours.

The obtained carboxyl group-containing polyurethane had a number average molecular weight of 12100, and the acid value of the solid part was 30.1 mg-KOH/g.

Synthesis Example 6

In a reaction vessel equipped with a stirrer, a thermometer and a condenser, 33 g of trimethylol propane (OH equivalent=44.72 g/eq.) and 165 g of ethyleneglycol acetate (manufacture by DAICEL CHEMICAL INDUSTRIES, LTD.) as solvent were placed, and the temperature was increased to 60˚C. After 132 g of toluene-2,4-diisocyanate (NCO equivalent=87.08 g/eq.) as polyisocyanate (a) was added thereto dropwise, the temperature was gradually increased to 80˚C and the reaction was continued for 2 hours at 80 ˚C. Subsequently, a solution obtained by dissolving 139 g of GI-1000 (OH-terminated hydrogenated polybutadiene, Mn= about 1500, OH equivalent=801 eq./g, solid content=100 w%: manufactured by NIPPON SODA CO., LTD.)as polyol compound (b) in 79.8 g of ethyleneglycol acetate as solvent was added thereto dropwise at 80 ˚C over an hour and addition reaction was carried out for 4 hours at 80 ˚C. The content of isocyanate contained in the thus obtained product was 4.7 % (NCO equivalent=894 g/eq.). Further, while keeping the temperature at 80 ˚C 63.2 g of methylethyl ketoxime (molecular weight:87.12) 63.2g as blocking agent was added dropwise over 2 hours, and reaction was further continued for an hour. At the time point when disappearance of NCO peak was confirmed by FT-IR(Fourier Transform Infrared Spectrometry), the temperature was cooled down, to thereby obtain terminal-blocked polyurethane resin. The obtained polyurethane had a number average molecular weight of 16000, and the blocked NCO equivalent weight (including solvent) was 1013 g/eq..

Synthesis Example 7

In a 5L-volume 4-neck flask equipped with a stirrer, condenser tube with an oil-water separator, nitrogen-introducing tube and a thermometer, 1000.0(0.50 mol) g of PLACCEL CD-220 (manufactured by DAICEL CHEMICAL INDUSTRIES, LTD., product name of 1,6-hexanediol-based polycarbonate diol) as polycarbonate diol (b), 250.27 g (1.00 mol) of 4,4'-diphenylmethane diisocyanate as s polyisocyanate (a) and 833.51 g of γ-butyrolactone (manufactured by Mitsubishi Chemical Corporation) were placed and the temperature was increased to 140˚C. Reaction was conducted 140 ˚C for 5 hours to thereby obtain oligomer having isocyanate groups at both terminals.

Further, into this reaction solution, 288.20 g (1.50 mol) of trimellitic anhydride was added and 125.14(0.50 mol) of 4,4'-diphenylmethane diisocyanate as polyisocyanate (a), and 1361.14 g of γ-butyrolactone were blended in and the temperature was increased to 160 ˚C, reaction was conducted for 6 hours. The obtained resin was diluted with butyrolactone to thereby obtain a polyamide imide solution having a viscosity of 160 Pa· s with 52 mass% of nonvolatile matter. The number average molecular weight of this resin was 18000.

Synthesis Example 8

In a reaction vessel equipped with a stirring apparatus, a thermometer and a condenser, 58.84 g(0.2 mol) 2,3,3',4'-biphenyl tetracarboxylic dianhydride and 120g of triglyme(hereinafter, sometimes referred to as "TG") as solvent were placed and the mixture was stirred while heating under nitrogen atmosphere at 180˚C. Then, 154.7g (0.17 mol) of α,ω-bis(3-aminopropyl) polydimethyl siloxane($NH_2$ equivalent=455 g/eq.) and 70 g of TG were added thereto and the resultant was stirred while heating at 180 ˚C for 60 minutes. Furthermore, to this reaction solution, 8.59 g(0.03 mol) of bis(3-carboxy-4-aminophenyl)methane and 23.4 g of TG were added. After stirred while heating at 180 ˚C for 5 hours, the resultant was filtrated. The thus obtained polyimide siloxane reaction solution had a polymer solid content of 50 mass % with ηinth 0.18 (ηinh: inherent viscosity; the ratio of the natural logarithm of the relative viscosity to the mass concentration of the polymer). The substantial imidization rate was 100 %.

Examples 1 to 9 and Comparative Examples 1 to 3 [Evaluation of the composition as thermosetting composition for overcoating]

<Preparation of Thermosetting resin composition>

Using resins of Synthesis Examples 1 to 8, the components other than surfactant and leveling agent were blended in at composition ratios shown in Table 1. Appropriate amounts of carbitol acetate were added in as viscosity adjuster at each blending step and each of the mixtures was kneaded by use of three-roll mill. After that, surfactant and leveling agent were added thereto and kneaded by use of a resin blender to thereby prepare sample composition.

[Evaluation of cured product]

Each of the thermosetting resin compositions of Examples 1 to 9 and Comparative Examples 1 to 3 was applied by screen-printing on substrate under conditions of using a screen of ST250-30, printing speed of 100mm/second, clearance between the printing board and the substrate of 2.0 mm, squeegee height of 80˚ and squeegee angle of 70˚. Measurements were conducted on the thus obtained product in terms of adhesion, silicone component, long-term reliability under the following conditions. The results were shown in Table 1.

[Defoaming property]

A 38 μm-thick polyimide film (Kapton (registered trademark) 150EN, manufactured by DU PONT-TOTAY CO., LTD.) was used as substrate. Each of the thermosetting resin compositions of Examples 1 to 7 and Comparative Examples 1 to 3 was applied by printing on the substrate and after 30 seconds, the number of bubbles remaining on an area of 50×50 mm was calculated and evaluation'was conducted with the following criteria.

○: 2 or less bubbles
×: 3 or more bubbles

[Silicone component]

A 38 μm-thick polyimide film (Kapton (registered trademark) 150EN, manufactured by DU PONT-TOTAY CO., LTD.) was used as substrate. Each of the thermosetting resin compositions of Examples 1 to 7 and Comparative Examples 1 to 3 was applied by printing on the substrate and after dried for 30 minutes at 80˚C, the composition was thermally cured at 150˚C for 24 hours. A part 1 mm from the edge of the printed portion was subjected to elemental analysis by SEM-EDS (scanning-type electronic microscope-energy dispersion type X-ray Spectrometry) and evaluation was conducted with the following criteria.

○ having Si content of less than 0.1 mass %
×: having Si content of 0.1 mass % or more

[Long-term reliability in insulating property]

An IPC-C (comb-shaped pattern), a commercially available substrate (IPC standard) was used as substrate. Each of the thermosetting resin compositions of Examples 1 to 7 and Comparative Examples 1 to 3 was applied by printing on the substrate and after dried for 30 minutes at 80 ˚C, it was thermally cured at 150 ˚C for an hour. To the substrate, bias voltage of 100 V was applied in an atmosphere of relative humidity of 85 % at 85 ˚C and after the substrate was left standing for 1000 hours, the insulating property was evaluated based on the following standards.

○: Neither migration nor decrease in insulation was observed resistance
×: Some migration or some decrease in insulation resistance was observed within 1000 hours.

[Adhesion]

A 38 μm-thick polyimide film (Kapton (registered trademark) 150EN, manufactured by DU PONT-TORAY CO., LTD.) was used as substrate. Each of the thermosetting resin compositions of Examples 1 to 7 and Comparative Examples 1 to 3 was applied by printing on the substrate and after dried for 30 minutes at 80 ˚C, the composition was thermally cured at 150 ˚C for an hour. The cured surface of the sample piece was bonded via an anisotropic conductive film (manufactured by Sony Chemical & Information Device Corporation, CP9420IS) to a 2-mm thick glass plate through

thermocompression. The thermocompression-bonded sample piece was subjected to 90-degree peeling test by using a tensile testing machine and the adhesion strength between the cured film and the polyimide film was measured and evaluation was conducted with the following criteria.

○: the adhesion strength of 10 N/cm or more
Δ: the adhesion strength of 8 N/cm or more and less than 10 N/cm
×: the adhesion strength of less than 8 N/cm or more

Table 1

| | | Example | | | | | | | | | Comparative Example | | |
|---|---|---|---|---|---|---|---|---|---|---|---|---|---|
| | | 1 | 2 | 3 | 4 | 5 | 6 | 7 | 8 | 9 | 1 | 2 | 3 |
| Synthesis Example 1 | | 20.0 | | | | | | | | | 20.0 | | 20.0 |
| Synthesis Example 2 | | | 20.0 | | 2.0 | | | | | | | 2.0 | |
| Synthesis Example 3 | | | | 20.0 | 18.0 | | | | | | | 18.0 | |
| Synthesis Example 4 | | | | | | 20.0 | | | | | | | |
| Synthesis Example 5 | | | | | | | 20.0 | | | | | | |
| Synthesis Example 6 | | | | | | | | 12.6 | | | | | |
| Synthesis Example 7 | | | | | | | | | 20.0 | | | | |
| Synthesis Example 8 | | | | | | | | | | 20.0 | | | |
| Curing agent | Epicoat 834 *1 | 1.92 | 1.68 | 1.92 | 1.92 | | 1.44 | | | | 1.92 | 1.90 | 1.90 |
| | Epicoat YX-8034 *2 | | | | | 2.20 | | | | | | | |
| | G-1000 *3 | | | | | | | 10.0 | | | | | |
| | YH-434 *4 | | | | | | | | 2.0 | | | | |
| | BurnockD-550 *5 | | | | | | | | | 2.0 | | | |
| | Epicoat 157S70 *6 | | | | | | | | | 0.2 | | | |
| | Tertiary amine curing catalyst: DBU *7 | | | | | | | | | 1.0 | | | |
| Surfactant(F-based) *8 | | 0.2 | 0.2 | 0.2 | 0.2 | 0.2 | 0.2 | 0.2 | 0.2 | 0.2 | | | |
| Surfactant(Si-based *9 | | | | | | | | | | | 0.2 | 0.2 | |
| Surfactant(PB-based) *10 | | | | | | | | | | | | | 0.2 |
| Leveling agent *11 | | 0.1 | 0.1 | 0.1 | 0.1 | 0.1 | 0.1 | 0.1 | 0.1 | 0.1 | 0.1 | 0.1 | 0.1 |
| Phthalocyanine Green | | 0.2 | 0.2 | 0.2 | 0.2 | 0.2 | 0.2 | 0.2 | 0.2 | 0.2 | 0.2 | 0.2 | 0.2 |
| Aerosil 50 *12 | | | | | | | | | | 3.6 | | | |
| Aerosil380 *12 | | | | | | | | | 0.73 | | | | |
| AerosilR-974 *12 | | 1.0 | 1.0 | 1.0 | 1.0 | 1.0 | 1.0 | 1.0 | | | 1.0 | 1.0 | 1.0 |
| Silicone Powder X-52-854 | | 1.0 | 1.0 | 1.0 | 1.0 | 1.0 | 1.0 | 1.0 | | | 1.0 | 1.0 | 1.0 |
| Barium sulfateB-30 | | 2.0 | 2.0 | 2.0 | 2.0 | 2.0 | 2.0 | 2.0 | | 8.0 | 2.0 | 2.0 | 2.0 |
| Micro AceP-30(Talc) | | | | | | | | | | 4.0 | | | |
| Defoaming property | | O | O | O | O | O | O | O | O | O | O | O | O |
| Silicone component | | O | O | O | O | O | O | O | O | O | × | × | O |
| Long-term electric reliability | | O | O | O | O | O | O | O | O | O | O | O | × |
| Adhesion | | O | O | O | O | O | O | O | O | O | O | △ | × |

*1: Bisphenol A-type epoxy resin

*2: Hydrogenated bisphenol A-type epoxy resin

*3: Terminal-hydrogenated 1,2-polybutadiene (manufactured by NIPPON SODA CO., LTD.)

*4: Manufactured by Tohto Kasei Co., Ltd.

*5: Manufactured by DAINIPPON INK AND CHEMICALS, INCORPORATED

*6: Manufactured by Japan Epoxy Resins, Co., Ltd.

*7: Manufactured by SAN-APRO, Ltd.

*8: Fluorine-based surfactant; PolyFOX PF6520 (manufactured by Omnova Solutions, Inc.)

*9: Silicone-based surfactant; TSF451(manufactured by GE TOSHIBA silicone Co., Ltd.)

*10: Polybutadiene-based surfactant; BYK-057(manufactured by BYK Chemie Japan K K)

*11: Leveling agent; Disparlon 230HF(manufactured by KUSUMOTO CHEMICALS, LTD.)

*12: Manufactured by Nippon Aerosil Co., Ltd.

**INDUSTRIAL APPLICABILITY**

As described above, according to the present invention, a thermosetting resin composition, excellent in defoaming property and leveling property at the time of printing without using a silicone defoaming agent, adhesion with substrate, warpage resistance, flexibility, plating resistance, soldering heat resistance and long-term reliability at high temperature and high humidity can be provided.

Accordingly, the thermosetting resin composition of the present invention can be applicable as thermosetting resin used for overcoating flexible circuit boards having excellent flexibility, thermosetting solder resist or electrically insulating material such as insulative interlayer film having excellent insulating property, or sealing material for IC or ULSI and in the field of or laminated plates.

In case of using thermosetting resin composition of the present invention as overcoating agent, such agents can be produced inexpensively as compared with a case of using conventionally used liquid polyimide material.

Moreover, conventional protective films have disadvantages that low molecular weight cyclic siloxane derived from silicone compound generates as out gas. On the other hand, in the present invention, which does not used silicone-based defoaming agent, a resin composition which can give a protective film well-balanced in good adhesion, low warpage and good long-term reliability of insulating property after curing, can be provided.

**Claims**

**1.** A thermosetting resin composition comprising the following components (A) to (C):

(A) thermosetting resin,
(B) inorganic fine particles and/or organic fine particles, and
(C) fluorine-containing polyether,

wherein (C) fluorine-containing polyether is a polymer having a fluorinated alkyl polyoxetane structure represented by formula (1) or (2),

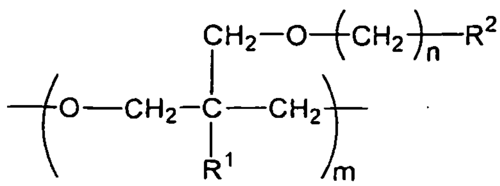

(1)

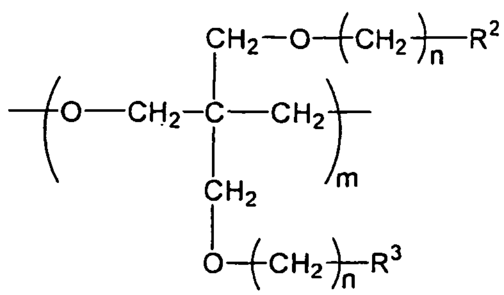

(2)

wherein m is an integer of 1 to 100, n is an integer of 1 to 6, R1 represents a hydrogen atom or an alkyl group having 1 to 6 carbon atoms, R2 and R3 each individually represent a straight-chain or branched chain alkyl group having 1 to 20 carbon atoms, with the proviso that at least 50% of hydrogen atoms present in the alkyl group is substituted by fluorine atoms and the other hydrogen atoms are substituted by hydrogen atoms, iodine atoms, chlorine atoms or bromine atoms;
or a composition containing copolymer which consists of a monomer having a fluorinated alkyl polyoxetane structure and an oxygen-containing monomer having 2 to 6 carbon atoms.

**2.** The thermosetting resin composition claimed in claim 1, wherein the blended amounts of the thermosetting resin as component (A), the inorganic fine particles and/or the organic fine particles as component (B) and the fluorine-containing polyether as component (C) based on the total amount of the thermosetting resin are as follows:

(A) from 20 to 90 mass%,
(B) from 10 to 80 mass% and
(C) from 0.1 to 5 mass%.

**3.** The thermosetting resin composition claimed in claim 1, wherein m in the formulae (1) and (2) described in claim 1 represents an integer of 2 to 30.

**4.** The thermosetting resin composition claimed in claim 1, wherein at least 75 % of hydrogen atoms present in the straight-chain or branched chain alkyl group having 1 to 20 carbon atoms represented by R2 and R3 in formulae (1) and (2) described in claim 3, is substituted by fluorine atoms.

**5.** The thermosetting resin composition claimed in claim 1, wherein the thermosetting resin(A) contains carboxyl group-containing urethane resin obtained by allowing the following materials to react:

(a) polyisocyanate compound,
(b) polyol compound,

(c) dihydroxy compound having a carboxyl group, and if necessary,
(d) monohydroxy compound and
(e) monoisocyanate compound.

**6.** The thermosetting resin composition claimed in claim 5, wherein the blending molar ratio of (a) diisocyanate compound,(b) polycarbonate diol, (c) dihydroxy compound,(d) monohydroxy compound and (e) monoisocyanate compound is as follows:

(a) : ((b) + (c)) =from 0.5 to 1.5:1 and,
(b) : (c) =1 : from 0.1 to 30,

and further in a case where (d) is used, the ratio is as follows:

((b)+(c)) = (a) and and preferably, the amount of (d) is from 0.5 to 1.5 times by mol based on excessive number of moles of NCO group,

in a case where (e) is used, the ratio is as follows:

(a)<((b)+(c)), and the amount of (e) is from 0.5 to 1.5 times by mol based on excessive number of moles of hydroxyl group.

**7.** The thermosetting resin composition claimed in claim 6, wherein the blending molar ratio of (a) diisocyanate compound,(b) polycarbonate diol, (c) dihydroxy compound,(d) monohydroxy compound and (e) monoisocyanate compound is as follows:

(a):((b)+(c))= from 0.8 to 1.2:1,
(b):(c)=1:from 0.3 to 10,

further in a case where (d) is used, the ratio is as follows:

((b)+(c)) = (a) and preferably, the amount of (d) is from 0.8 to 1.2 times by mol based on excessive number of moles of NCO group, and

in a case where (e) is used, the ratio is as follows:

(a)<((b)+(c)) and the amount of (e) is from 0.8 to 1.2 times by mol based on excessive number of moles of hydroxyl group.

**8.** The thermosetting resin composition claimed in claim 1, containing the inorganic and/or organic fine particles(B) claimed in claim 1, at 5 to 40 mass % based on the total amount of the thermosetting resin composition, wherein the inorganic fine particle is at least one kind selected from the group consisting of silica, alumina, titanium oxide, barium sulfate, talc, calcium carbonate, glass powder and quartz powder, and the organic fine particle is at least one kind selected from the group consisting of epoxy resin powder, melamine resin powder, urea resin powder, guanamine resin powder, polyester resin powder and silicone powder.

**9.** The thermosetting resin composition claimed in claim 1, wherein the fluorine-containing polyether (C) described in claim 1 is copolymer of epoxy cpompound, oxetane compound and/or tetrahydrofuran derivative and fluorooxetane.

**10.** An overcoating agent comprising the thermosetting resin composition claimed in any one of claims 1 to 9.

**11.** A surface protection film for substrate of flexible circuit boards, comprising the overcoating agent claimed in claim 10.

**12.** An ink for permanent insulating protective film comprising the thermosetting resin composition claimed in any one of claims 1 to 11.

**13.** A cured prodcut obtained by curing the ink for permanent insulating protective film claimed in claim 12.

**14.** An electronic component comprising the cured product claimed in claim 13.

## Patentansprüche

1. Hitzehärtende Harzzusammensetzung, welche die folgenden Komponenten (A) bis (C) enthält:

   (A) hitzehärtendes Harz,
   (B) anorganische Feinteilchen und/oder organische Feinteilchen und
   (C) Fluor-enthaltenden Polyether,

   wobei (C) der Fluor-enthaltende Polyether ein Polymer mit einer fluorierten Alkylpolyoxetan-Struktur der Formel (1) oder (2) ist

   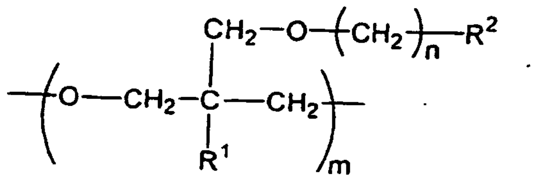

   (1)

   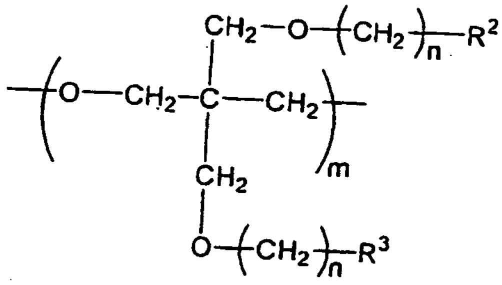

   (2)

   worin m eine ganze Zahl von 1 bis 100 ist, n eine ganze Zahl von 1 bis 6 ist, R1 ein Wasserstoffatom oder eine Alkylgruppe mit 1 bis 6 Kohlenstoffatomen ist, R2 und R3 jeweils unabhängig voneinander eine geradkettige oder verzweigte Alkylgruppe mit 1 bis 20 Kohlenstoffatomen darstellen, mit der Maßgabe, dass mindestens 50 % der in der Alkylgruppe vorhandenen Wasserstoffatome durch Fluoratome substituiert sind und
   die anderen Wasserstoffatome durch Wasserstoffatome, Iodatome, Chloratome oder Bromatome substitutiert sind; oder eine Zusammensetzung, welche ein Copolymer enthält, das aus einem Monomer mit einer fluorierten Alkylpolyoxetan-Struktur und einem Sauerstoff-enthaltenden Monomer mit 2 bis 6 Kohlenstoffatomen besteht.

2. Hitzehärtende Harzzusammensetzung nach Anspruch 1, wobei die Mischmengen des hitzehärtenden Harzes als Komponente (A), der anorganischen Feinteilchen und/oder der organischen Feinteilchen als Komponente (B) und des Fluor-enthaltenden Polyethers als Komponente (C), bezogen auf die Gesamtmenge des hitzehärtenden Harzes, wie folgt sind:

   (A) 20 bis 90 Massen-%
   (B) 10 bis 80 Massen-% und
   (C) 0.1 bis 5 Massen-%.

3. Hitzehärtende Harzzusammensetzung nach Anspruch 1, wobei m in den Formeln (1) und (2) des Anspruchs 1 eine ganze Zahl von 2 bis 30 darstellt.

4. Hitzehärtende Harzzusammensetzung nach Anspruch 1, wobei mindestens 75 % der Wasserstoffatome in der durch die Substituenten R2 und R3 in den Formel (1) und (2) des Anspruchs 3 dargestellten geradkettigen oder verzweigten Alkylgruppe mit 1 bis 20 Kohlenstoffatomen durch Fluoratome substituiert sind.

5. Hitzehärtende Harzzusammensetzung nach Anspruch 1, wobei das hitzehärtende Harz (A) durch Umsetzen der folgenden Materialien erhaltenes Carboxygruppen-enthaltendes Urethanharz enthält:

(a) Polyisocyanatverbindung,
(b) Polyolverbindung,
(c) Dihydroxyverbindung mit einer Carboxygruppe und, falls erforderlich,
(d) Monohydroxyverbindung und
(e) Monoisocyanatverbindung.

6. Hitzehärtende Harzzusammensetzung nach Anspruch 5, wobei das Molverhältnis der Mischung aus (a) Diisocyanatverbindung, (b) Polycarbonatdiol, (c) Dihydroxyverbindung, (d) Monohydroxyverbindung und (e) Monoisocyanatverbindung wie folgt ist:

(a) : ((b) + (c)) = 0,5 bis 1,5 : 1 und,
(b) : (c) = 1 : 0,1 bis 30,

und, wenn (d) eingesetzt wird, das Verhältnis wie folgt ist:

((b) + (c)) = (a) und vorzugsweise die Menge von (d) die 0,5-bis 1,5-fache Molmenge, bezogen auf die Überschussmolmenge an NCO-Gruppen, ist

und, wenn (e) eingesetzt wird, das Verhältnis wie folgt ist:

(a) < ((b) + (c)), und die Menge von (e) die 0,5- bis 1,5-fache Molmenge, bezogen auf die Überschussmolmenge an Hydroxygruppen, ist.

7. Hitzehärtende Harzzusammensetzung nach Anspruch 6, wobei das Molverhältnis der Mischung aus (a) Diisocyanatverbindung (b) Polycarbonatdiol, (c) Dihydroxyverbindung, (d) Monohydroxyverbindung und (e) Monoisocyanatverbindung wie folgt ist:

(a) : ((b) + (c)) = 0,8 bis 1,2 : 1,
(b) : (c) = 1 : 0,3 bis 10,

und, wenn (d) eingesetzt wird, das Verhältnis wie folgt ist:

((b) + (c)) = (a) und vorzugsweise die Menge von (d) die 0,8-bis 1,2-fache Molmenge, bezogen auf die Überschussmolmenge an NCO-Gruppen, ist

und, wenn (e) eingesetzt wird, das Verhältnis wie folgt ist:

(a) < ((b) + (c)), und die Menge von (e) die 0,8- bis 1,2-fache Molmenge, bezogen auf die Überschussmolmenge an Hydroxygruppen, ist.

8. Hitzehärtende Harzzusammensetzung nach Anspruch 1, welche die anorganischen und/oder organischen Feinteilchen (B) nach Anspruch 1 zu 5 bis 40 Massen-%, bezogen auf die Gesamtmenge der Hitzehärtenden Harzzusammensetzung, enthält, wobei das anorganische Feinteilchen mindestens eine Art ist, die aus der Gruppe ausgewählt ist, die aus Siliciumdioxid, Aluminiumoxid, Titanoxid, Bariumsulfat, Talc, Calciumcarbonat, Glaspulver und Quarzpulver besteht, und das organische Feinteilchen mindestens eine Art ist, die aus der Gruppe ausgewählt ist, die aus Epoxyharzpulver, Melaninharzpulver, Harnstoffharzpulver, Guanaminharzpulver, Polyesterharzpulver und Siliconpulver besteht.

9. Hitzehärtende Harzzusammensetzung nach Anspruch 1, wobei der Fluor-enthaltende Polyether (C) des Anspruchs 1 ein Copolymer einer Epoxyverbindung, Oxetanverbindung und/oder Tetrahydrofuranderivat und Fluoroxetan ist.

**10.** Überzugsmittel, welches die Hitzehärtende Harzzusammensetzung nach einem der Ansprüche 1 bis 9 enthält.

**11.** Oberflächenschutzfilm für ein Substrat einer flexiblen Schalterplatte, welcher das Überzugsmittel nach Anspruch 10 enthält.

**12.** Druckerfarbe für einen permanent isolierenden Schutzfilm, welche die Hitzehärtende Harzzusammensetzung nach einem der Ansprüche 1 bis 11 enthält.

**13.** Gehärtetes Produkt, erhalten durch Härten der Druckerfarbe für den permanenten isolierenden Schutzfilm nach Anspruch 12.

**14.** Elektronische Komponente, welche das in Anspruch 13 beanspruchte gehärtete Produkt enthält.

## Revendications

**1.** Composition de résine thermodurcissable comprenant les composants (A) à (C) suivants :

(A) résine thermodurcissable,
(B) particules inorganiques fines et/ou particules organiques fines et
(C) polyéther contenant du fluor

où le polyéther contenant du fluor (C) est un polymère ayant une structure alkylpolyoxétane fluoré représentée par la formule (1) ou (2),

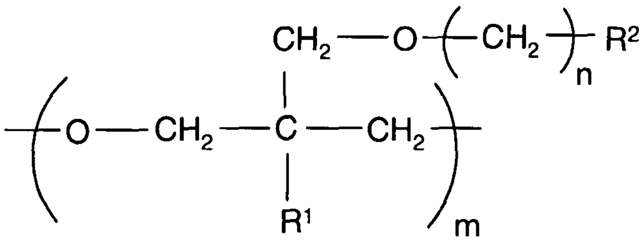

(1)

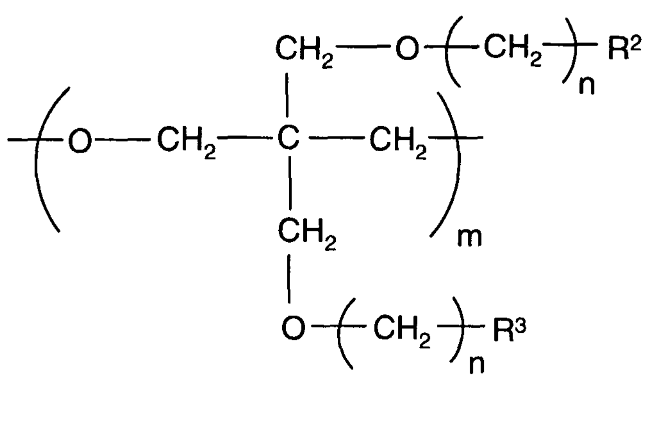

(2)

où m est un entier de 1 à 100, n est un entier de 1 à 6, $R^1$ représente un atome d'hydrogène ou un groupe alkyle ayant de 1 à 6 atomes de carbone, $R^2$ et $R^3$ représentent chacun individuellement un groupe alkyle à chaîne droite ou à chaîne ramifiée ayant de 1 à 20 atomes de carbone, à condition qu'au moins 50 % des atomes d'hydrogène présents dans le groupe alkyle soient substitués par des atomes de fluor et que les autres atomes d'hydrogène soient substitués par des atomes d'hydrogène, des atomes d'iode, des atomes de chlore ou des atomes de brome ; ou composition contenant un copolymère qui est constitué d'un monomère ayant une structure alkylpolyoxétane fluoré et un monomère contenant de l'oxygène ayant de 2 à 6 atomes de carbone.

2. Composition de résine thermodurcissable selon la revendication 1, où les quantités mélangées de résine thermodurcissable en tant que composant (A), des particules inorganiques fines et/ou des particules organiques fines en tant que composant (B) et de polyéther contenant du fluor en tant que composant (C) par rapport à la quantité totale de résine thermodurcissable sont comme suit :

   (A) de 20 à 90 % en masse,
   (B) de 10 à 80 % en masse et
   (C) de 0,1 à 5 % en masse.

3. Composition de résine thermodurcissable selon la revendication 1, où m dans les formules (1) et (2) selon la revendication 1 représente un entier de 2 à 30.

4. Composition de résine thermodurcissable selon la revendication 1, où au moins 75 % des atomes d'hydrogène présents dans le groupe alkyle à chaîne droite ou à chaîne ramifiée ayant de 1 à 20 atomes de carbone représenté par $R^2$ et $R^3$ dans les formules (1) et (2) selon la revendication 3 sont substitués par des atomes de fluor.

5. Composition de résine thermodurcissable selon la revendication 1, où la résine thermodurcissable (A) contient une résine d'uréthane contenant des groupes carboxyle, obtenue en mettant à réagir les substances suivantes :

   (a) composé de polyisocyanate,
   (b) composé de polyol,
   (c) composé dihydroxy ayant un groupe carboxyle et si nécessaire
   (d) composé monohydroxy et
   (e) composé monoisocyanate.

6. Composition de résine thermodurcissable selon la revendication 5, où le rapport molaire du mélange de (a) composé diisocyanate, (b) polycarbonatediol, (c) composé dihydroxy, (d) composé monohydroxy et (e) composé monoisocyanate est le suivant :

   (a) : ((b) + (c) = de 0,5 à 1,5 : 1 et
   (b) : (c) = 1 : de 0,1 à 30,

   et en outre dans le cas où (d) est utilisé, le rapport est comme suit :

   ((b) + (c)) = (a) et de préférence la quantité de (d) est de 0,5 à 1,5 fois en mole par rapport au nombre de moles en excès du groupe NCO,

   dans le cas où (e) est utilisé, le rapport est comme suit :

   (a) < ((b) + (c)), et la quantité de (e) est de 0,5 à 1,5 fois en mole par rapport au nombre de moles en excès du groupe hydroxyle.

7. Composition de résine thermodurcissable selon la revendication 6, où le rapport molaire de mélange de (a) composé diisocyanate, (b) polycarbonate diol, (c) composé dihydroxy, (d) composé monohydroxy et (e) composé monoisocyanate est comme suit :

   (a) : ((b) + (c)) = de 0,8 à 1,2 : 1,
   (b) : (c) = 1 : de 0,3 à 10,

   en outre dans le cas où (d) est utilisé, le rapport est comme suit :

   ((b) + (c)) = (a) et de préférence, la quantité de (d) est de 0,8 à 1,2 fois en mole par rapport au nombre de moles en excès du groupe NCO et

   dans le cas où (e) est utilisé, le rapport est comme suit :

   (a) < ((b) + (c)) et la quantité de (e) est de 0,8 à 1,2 fois en mole par rapport au nombre de moles en excès du groupe hydroxyle.

**8.** Composition de résine thermodurcissable selon la revendication 1, contenant les particules fines organiques et/ou inorganiques (B) selon la revendication 1 à raison de 5 à 40 % en masse par rapport à la quantité totale de composition de résine thermodurcissable, où la particule inorganique fine est au moins un type sélectionné dans le groupe constitué de la silice, de l'alumine, de l'oxyde de titane, du sulfate de baryum, du talc, du carbonate de calcium, de la poudre de verre et de la poudre de quartz et la particule organique fine est au moins un type sélectionné dans le groupe constitué de la poudre de résine époxy, de la poudre de résine de mélamine, de la poudre de résine d'urée, de la poudre de résine de guanamine, de la poudre de résine de polyester et de la poudre de silicone.

**9.** Composition de résine thermodurcissable selon la revendication 1, où le polyéther contenant du fluor (C) selon la revendication 1 est un copolymère de composé époxy, de composé oxétane et/ou de dérivé de tétrahydrofurane et de fluoroxétane.

**10.** Agent de recouvrement comprenant la composition de résine thermodurcissable selon l'une quelconque des revendications 1 à 9.

**11.** Film protecteur superficiel pour substrat de plaquettes de circuits imprimés souples, comprenant l'agent de recouvrement selon la revendication 10.

**12.** Encre pour film protecteur isolant permanent comprenant la composition de résine thermodurcissable selon l'une quelconque des revendications 1 à 11.

**13.** Produit durci obtenu par durcissement de l'encre pour le film protecteur isolant permanent selon la revendication 12.

**14.** Composant électronique comprenant le produit durci selon la revendication 13.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001059071 A
- JP 2003327913 A
- JP 2004124015 A
- JP 2000186248 A
- US 6433123 B
- US H11071551 A
- JP 2001302795 A
- JP 2004137370 A
- JP 2004211055 A
- JP 2004169042 A
- JP 2004211064 A
- JP 2004535485 A
- WO 2002092660 A